(19) **Europäisches Patentamt / European Patent Office / Office européen des brevets**

(11) **EP 3 729 516 B1**

(12) **EUROPEAN PATENT SPECIFICATION**

(45) Date of publication and mention
of the grant of the patent:
**12.07.2023 Bulletin 2023/28**

(21) Application number: **18825691.1**

(22) Date of filing: **20.12.2018**

(51) International Patent Classification (IPC):
**H01L 31/048** (2014.01)     **H01L 31/0216** (2014.01)

(52) Cooperative Patent Classification (CPC):
**H01L 31/02167; H01L 31/02168; H01L 31/0481;**
Y02E 10/50; Y02E 10/52

(86) International application number:
**PCT/EP2018/086096**

(87) International publication number:
**WO 2019/122079 (27.06.2019 Gazette 2019/26)**

(54) **SOLAR CELLS**

SOLARZELLEN

CELLULES SOLAIRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.12.2017 EP 17210122**

(43) Date of publication of application:
**28.10.2020 Bulletin 2020/44**

(73) Proprietor: **Merck Patent GmbH
64293 Darmstadt (DE)**

(72) Inventors:
• **HUNGER, Marc
68519 Viernheim (DE)**
• **TASCH, Johannes
99974 Muehlhausen (DE)**

• **PLATZER, Cairon
64291 Darmstadt (DE)**
• **DOLL, Oliver
63128 Dietzenbach (DE)**
• **WIERZCHOWIEC, Piotr
69118 Heidelberg (DE)**
• **BARTH, Sebastian
64291 Darmstadt (DE)**
• **DELOUX, Laurent
69115 Heidelberg (DE)**

(56) References cited:
| | |
|---|---|
| EP-A1- 2 292 560 | WO-A2-2007/050756 |
| WO-A2-2009/143407 | WO-A2-2012/021460 |
| JP-A- 2010 212 381 | JP-B2- 5 648 906 |
| KR-A- 20110 022 684 | US-A1- 2011 023 943 |
| US-A1- 2012 308 667 | |

EP 3 729 516 B1

**Description**

The invention relates to solar cells or solar cell modules comprising a layer comprising effect pigments consisting of a transparent or semi-transparent flake-form substrate coated with one or more layers of transparent or semi-transparent materials and optionally a post coating, and a process for their preparation.

Solar cells showed a great success over the last years and will surpass the global annual grid connected installation of 100 GW in 2017 with the majority being installed in utility scale. The basic function of all solar cells is the same: A photoactive material absorbs light and generates an excited electron-hole pair. This electron-hole pair is separated within the solar cell by areas with different mobilities for electrons and holes - a so called p-n junction. As different kinds of light absorbing materials can be used, the solar industry knows several different kinds of solar cell technologies:

1) Crystalline silicon solar cells (mono crystalline c-Si and multi crystalline mc-Si)
2) Cadmium-Telluride Solar cells (CdTe)
3) Copper-Indium-Gallium-Diselenide (CIGS/CIS)
4) Amorphous silicon solar cells (a-Si)
5) III/V solar cells like Gallium-Arsenide (GaAs) solar cells or multi-junction solar cells consisting of stacks of group III and group V elements like Germanium/Indium-(Aluminium)-Gallium-Arsenide or phosphide (In(Al)GaAs/P)
6) Dye sensitized solar cells (DSSC)
7) Organic solar cells (OSC)
8) Perovskite solar cells (PSC)
9) Quantum dot solar cells (QSC)
10) Other II/VI solar cells consisting of elements of group II and group VI like Zinkselenide (ZnSe) or Ironsulfide (FeS)
11) Tandem solar cells

However, to use more surfaces of buildings and other surfaces on objects (e.g. cars) would increase the overall surface areas you can use for solar energy production. For this new techniques and approaches to make solar cells with appealing colors and to increase efficiencies under different absorption angles are of major interest for the solar energy business.

The use of pigments in solar cells for cooling is described in JP 5648906 B2. The pigments are used to reflect a part of IR solar radiation to reduce the operating temperature of the solar cells. WO 07/050756, WO 09/143407, and US 2011/023943 disclose protective sheets comprising selected polymer films and layers of special polymers, which optionally comprise stabilizers, dyes, pigments, flakes, other additives, or mixtures thereof for photovoltaic modules.

Today the options and technologies to get colored solar cells are limited:

(1) Use the limited color options of Si-Layers and other technologies;
(2) Color by change of the anti-reflective coating;
(3) Use of colored glass;
(4) Use of reflective interlayers.

Most technologies and materials are not giving nice colors and the coloration goes along with significant loss in efficiency of the solar cell or they are expensive due to high production costs (multi-layer technologies). Efficiency losses in the range of 15 - 40% are possible.

WO 2007/050756 A2 discloses a multilayer sheet for use as integrated backing and encapsulation layer of photovoltaic modules, wherein the sheet contains a polymer layer that may additionally contain flakes or effect pigments.

The object of the invention is to offer an efficient material and method to color state of the art solar cells or solar cell modules

This objective is solved by a solar cell or a solar cell module comprising at least one layer on or in the front radiation-receiving side of the solar cell or the solar cell module comprising at least one effect pigment consisting of a transparent or semi-transparent flake-form substrate coated with one or more layers of transparent or semi-transparent materials and optionally with a post coating, characterized in that the effect pigment has a reflection level of 1 to 40 % for radiation in the range of 260 to 1200 nm, and the amount of the effect pigment is in the range of 1-25 g/m$^2$, and a process wherein a coating composition comprising such effect pigment is applied to the solar cells or solar cell modules.

The term "on or in the front radiation-receiving side" means that the pigmented layer may cover the solar cells or solar cell modules or the pigmented layer may be applied on the inside of the glass or on a protective foil or on an exterior foil applied on top of a finished solar cell or solar cell module. In other words, the pigmented layer is located within the visible parts of the solar cells or solar cell modules. The pigmented layer may be applied by spraying, coating or printing as well as a lamination foil.

The present invention offers a highly efficient material and method to color state of the art (single) solar cells and solar cell modules made of a plurality of electrically interconnected solar cells with great flexibility and achieving huge range of different colors with low or negligible loss in solar cell efficiency, and high level of long term stability. Additionally, the invention provides a solution to achieve a high color uniformity where no bus bars and in solar cell modules no single solar cells are visible and at the same time low or negligible loss of solar cell efficiency is achieved.

Surprisingly it has been found that effect pigments according to the invention are ideal to give sufficient color when printed on glass or Si or used in EVA films (ethyl vinyl acetate films) without reducing the overall solar cell efficiency significantly. Long term test showed high level of stability. A climate chamber damp heat 1000 test (as described in: http://sinovoltaics.com/learning-center/testing/damp-heat-test/) showed no impact on the long-term stability of the manufactured single cell solar modules with a effect pigment layer in any binder directly printed on top of the solar cell. As the direct contact between the effect pigment containing layer and the solar cell is the most demanding location in the setup of a solar module, no negative effect in any position of the solar module stack can be assumed.

The effect pigments are reflecting a part of the visible sun light, but they let pass the light needed to create energy. These effect pigments can even be orientated in a way so that you can module the angle of best efficiency and can play with color and efficiency. The ability to apply effect pigments easily to state of the art solar cells or solar cell modules makes the application even more efficient.

The invention thus relates to the use of flake-form effect pigments in solar cells. Especially, the invention relates to solar cells or solar cell modules comprising effect pigments consisting of a transparent or semi-transparent flake-form substrate coated with one or more layers of transparent or semi-transparent materials. By use of the invention, the visual appearance of solar cells and solar modules can be adapted to special needs. The exterior visual appearance of objects comprising solar cells such as buildings, devices, automotive, etc. can be improved and transparency and reflectivity of the solar cells can be controlled. Furthermore, the visibility of the cells and the bright colored bus bars are avoided when a dark back sheet is used and the bus bars and connection points are darkened. Also, the invention can be used to provide solar cells or solar cell modules with extraordinary colors to achieve special effects and designs, for example depending on the used effect pigment also a texture could be added, means e.g. a sparkle effect on the panels.

A main advantage of the invention is the possibility to seamlessly integrate solar cells or solar cell modules into any surface by changing the appearance to a neutral look which people are used to. The coloration of the solar cells or solar cell modules is possible over a variety of colors and not limited to a rigid substrate like glass or a single solar cell technology. Additionally, any complex solutions like another layer in the lamination stack is not necessarily needed.

Additionally, the costs of solar power are not increased in a significant way, because the efficiency of the solar cells or solar cell modules is not impacted too heavily in contrast to currently available technologies, which have the great drawback of an impact on the solar cell performance, where under real life conditions the efficiency of solar cells drops below 10% from an initial performance of >15%.

Surprisingly, effect pigments show the possibility to homogeneously color solar cells with a minor impact on cell efficiency if the concentration of the effect pigment is chosen accordingly. Surprisingly, it has been found that especially conventional effect pigments such as pearlescent pigments, interference pigments and/or multi-layer pigments show the effects. As the working principle of these effect pigments is based on a selected reflection of a specific wavelength area, the color effect can be tuned selectively and the resulting efficiency can be directly correlated to reflected portion of light. In general, a desired color-effect can already be obtained at low reflections of a specific wavelength. The performance can even be increased in dedicated wavelength of 700 to 1100 nm detected by some flakes - being important for the quantum efficiency. Long term stability of whole system is tested positively.

A coating composition comprising an effect pigment comprising a transparent or semi-transparent flake-form substrate coated with one or more layers of transparent or semi-transparent materials, a solvent system, a organic or inorganic binder system or a mixture thereof for fixation of the effect pigments, and optionally one or multiple additives is applied to the solar cell or solar cell module.

As the effect pigments can locally and flexibly be applied on any surface all different applications can be served:

1) Effect pigment coating can be applied on the exterior of a finished solar cell or solar cell module, on the protective substrate covering the solar cell or solar cell module (glass or plastic), on or in any lamination material like EVA (ethyl vinyl acetate film), TPU (thermoplastic polyurethane) or silicone or directly on the photoactive material/solar cells.

2) Effect pigment layer can be applied by spraying, coating or several printing methods such as gravure printing, flexo printing, offset printing, tampon printing, preferably screen printing, (micro) spray coating, dip coating, slot-die coating, doctor blade/knife coating, dispensing, laser-assisted transfer, curtain coating, film transfer coating, aerosol jetting, powder coating, inkjet printing, brushing or similar methods.

3) Applications in any typically pigmented surface like buildings, communication and transportation objects such as for example cars, trains, trucks, trailers, manual devices, ships, price tags, plastics, wearable items and home appliances or similar.

4) The invention can be applied to any kind of solar cell technologies including amorphous, mono- and multi crystalline silicon solar cells, CIGS, CdTe, III/V solar cells, II/VI solar cells, Perovskite solar cells, organic solar cells and dye sensitized solar cells as well as solar cell modules made out of single cells. Crystalline solar cells include cell structures like Al-BSF, PERC, PERL, PERT, HIT, IBC, bifacial or any other cell type based on crystalline silicon substrates.

5) The invention can be used to seamlessly integrate solar cells into buildings (façade and roof), portable and installed devices, automotive vehicles (cars, motorcycles, scooters, trucks and similar) or other kinds of solar installations where the typical technical look of solar cells would make a change to the typical appearance people are used to and long-term stability is essential.

The effect pigment layers render appearance of solar cells' front surfaces to different colors, as e. g. red, violet, green etc. Effect pigment layers may comprise different layer thicknesses as well as different concentrations of effect pigment particles.

The invention provides the possibility to seamlessly integrate solar cells into any surface by changing the appearance to a neutral look which people are used to. Advantageously, the present invention enables the incorporation of solar cells into many kinds of surfaces such as buildings, cars, hand hold devices or any other highly visible surface that needs a seamless integration of solar cells without changing the optical appearance. To hide the space between single cells and the bus bars, conducting path and soldering points, a grid of dark color (solar cell blue or black) can be incorporated into any layer of the solar module to hide those areas as long as the effect pigment layer comes on top of this. To hide the space between the single cells, a black or dark solar blue back layer behind the cells can be used. This can be printed or a foil.

Advantageously, pigmented coatings of the invention may also be used as anti-reflective coatings.

The effect pigments used according to the invention are preferably transparent or at least semi-transparent. The effect pigments useful for the invention exhibit preferably a green color. However, other colors like blue, grey, white, violet, red, orange, black are also suitable. Other colors or their mixture to produce specific colors and shades can be used. The effect pigments can also produce metallic effects, such as but not limited to: silver, platinum, gold, copper and variety of other metals. It is also possible to create a printed images / pictures using a mixture of different colors.

The effect pigments and/or the effect pigment layer of the invention preferably selectively reflect 5-40%, of the visible light of the solar spectrum, while a reflectance of 5% in e.g. the range of 450-550 nm is sufficient to obtain a strong green color impression of an else optically blue solar cell.

The effect pigments and/or the effect pigment layer of the invention preferably have a transparency for radiation relevant for the specific solar cell or solar cell module, preferably for radiation in the range of 260 to 1200 nm, of at least 30%, preferably > 80%.

Preferably, the effect pigments and/or the effect pigment layer have a reflection level of 1 to 40 % preferable < 30% for radiation in the range of 260 to 1200 nm.

Especially, the effect pigments and/or the effect pigment layer have a reflection level of < 20%, preferable < 10% for radiation in the range of 260 to 1200 nm.

Besides their specific color, the layer of effect pigments shows a high level (at least 30%, preferably >80%) of transparency for radiation relevant for the specific solar cell, preferably for radiation in the range of 260 to 1200 nm and preferably a reflection level of about 5 to 40 %, preferable below 10%. Internal and external quantum efficiency is preferably ≥ 60% (≥ 0.6), preferably ≥ 70% (≥ 0.7) and preferably of (≥ 0,8) ≥ 80% in the area of 260 to 1200 nm wavelength. Internal and external quantum efficiency is preferably 60% at a reflection of 40% and preferably of > 80% in the area of 260 to 1200 nm wavelength. The quantum efficiency describes the amount of photons used for electricity generation. The external quantum efficiency (EQE) describes the wavelength selective relation of the amount of total photons shining on the solar cell in correlation to the amount of photons absorbed by the solar cell and efficiently converted into electricity. The internal quantum efficiency (IQE) describes the relation of the amount of photons which arrive in the solar cell and are converted to electricity. In the case of the invention the difference between the internal and external quantum efficiency can be described in a way:

$$EQE = IQE - \text{reflected photons by the effect pigment layer.}$$

The high level of the both the IQE and EQE thus shows the limited impact of the effect pigments on the solar cell performance. The effect pigments and/or the effect pigment layer create a relative current loss $[A/m^2]$ of less than 40 %, preferably less than 30%, most preferably less than 20%. Thus, the effect pigment and/or the effect pigment layer creates an efficiency reduction [W/m$^2$] of less than 40 %, preferable less than 30%, most preferably less than 20%.

Impacts of pigments and layers onto c-Si solar cells are assessed by reflection data. Reflection data are used to estimate max. power absorption / max. photo current generation of treated cells. Reflection and transmission measurements and calculations are conducted by common methods known to the person skilled in the art and as described further in the experimental section.

A reference with a TPU based encapsulant shows a typical EQE of 90% over a wide wavelength, an effect pigment mixture according to the invention leading to a white/grey appearance of the solar cell shows a drop by ~7% and a green effect pigment according to the invention based on coated glass flakes shows an averaged drop below 5% and even an increase of the quantum efficiency in the IR region.

The effect pigments employed in accordance with the invention preferably have a flake-form substrate which comprises at least one coating comprising a metal oxide, metal oxide hydrate or mixtures thereof. Preferably, the effect pigments consist of transparent or semi-transparent, colorless, flake-form substrates, which have been coated with one or more layers of transparent or semi-transparent, colorless materials. Preference is given to the use of pearlescent pigments, interference pigments, and/or multi-layer pigments. Long term stability of the effect pigments can preferably be improved with using a post coating of organic coatings and/or inorganic coatings as last layers of the effect pigments like described in WO 2011/095326 A1 and below.

Suitable substrates for the effect pigments are, for example, all known coated or uncoated, flake-form substrates, preferably transparent or semi-transparent, preferably colorless flakes. Suitable are, for example, phyllosilicates, in particular synthetic or natural mica, glass flakes, $SiO_2$ flakes, $Al_2O_3$ flakes, $TiO_2$ flakes, liquid crystal polymers (LCPs), holographic pigments, BiOCl flakes or mixtures of the said flakes. Aluminum flakes with dielectric coatings can also be used according to the invention at low concentrations to obtain a very high hiding power of the active photovoltaic layer.

The glass flakes can consist of all glass types known to the person skilled in the art, for example of A glass, E glass, C glass, ECR glass, recycled glass, window glass, borosilicate glass, Duran® glass, labware glass or optical glass. The refractive index of the glass flakes is preferably 1.45-1.80, in particular 1.50-1.70. Especially preferred glass flakes consist of A glass, C glass, E glass, ECR glass, quartz glass and borosilicate glass.

Preference is given to coated or uncoated flakes of synthetic or natural mica, $SiO_2$ flakes, $Al_2O_3$ flakes, and glass flakes, in particular glass flakes of C glass, ECR glass or calcium aluminum borosilicate. Especially, effect pigments based on calcium aluminum borosilicate glass are preferably used. In a variant of the invention $Al_2O_3$ flakes are preferred.

The substrates generally have a thickness of between 0.01 and 5 μm, in particular between 0.05 and 4.5 μm and particularly preferably from 0.1 to 1 μm. The length or width dimension is usually from 1 to 500 μm, preferably from 1 to 200 μm and in particular from 5 to 125 μm. They generally have an aspect ratio (ratio of mean diameter to mean particle thickness) of from 2:1 to 25,000:1, preferably from 3:1 to 1000:1 and in particular from 6:1 to 250:1. The said dimensions for the flake-form substrates in principle also apply to the coated effect pigments used in accordance with the invention, since the additional coatings are generally in the region of only a few hundred nanometers and thus do not significantly influence the thickness or length or width (particle size) of the effect pigments.

The particle size and the particle size distribution of the effect pigments and their substrates can be determined by various methods usual in the art. However, use is preferably made of the laser diffraction method in a standard process by means of a Malvern Mastersizer 2000, Beckman Coulter, Microtrac, etc. In addition, other technologies such as SEM (scanning electron microscope) images can be used.

In a preferred embodiment, the substrate is coated with one or more transparent or semitransparent layers comprising metal oxides, metal oxide hydrates, metal hydroxides, metal suboxides, metal fluorides, metal nitrides, metal oxynitrides or mixtures of these materials. Preferably, the substrate is partially or totally encased with these layers.

Furthermore, multilayered structures comprising high- and low-refractive-index layers may also be present, where high- and low-refractive-index layers preferably alternate. Particular preference is given to layer packages comprising a high-refractive-index layer (refractive index $\geq$ 2.0) and a low-refractive-index layer (refractive index < 1.8), where one or more of these layer packages may have been applied to the substrate. The sequence of the high- and low-refractive-index layers can be matched to the substrate here in order to include the substrate in the multilayered structure.

Particular preference is given to metal oxides, metal oxide hydrates or mixtures thereof, preferably of Ti, Sn, Si, Al, Zr and Zn, especially of Ti, Sn and Si. Oxides and/or oxide hydrates may be present in a single layer or in separate layers. Particularly, titanium dioxide, in the rutile or anatase modification, preferably in the rutile modification is used. For conversion of titanium dioxide into the rutile modification, a tin dioxide layer is preferably applied beneath a titanium dioxide layer. Preferred multi-layer coatings comprise alternating high- and low-refractive-index layers, preferably such as $TiO_2$ - $SiO_2$ - $TiO_2$.

The layers of metal oxides, hydroxide and/or oxide hydrates are preferably applied by known wet-chemical methods, where the wet-chemical coating methods developed for the preparation of effect pigments, which result in enveloping of the substrate, can be used. After the wet-chemical application, the coated products are subsequently separated off, washed, dried and preferably calcined.

The thickness of the individual layers thereof is usually 10 to 1000 nm, preferably 15 to 800 nm, in particular 20 to 600 nm, especially 20 to 200 nm.

In order to increase the light, temperature, water and weather stability, the effect pigment may be subjected to post-coating or post-treatment. The post coating may be an organic coating and/or an inorganic coating as last layer/s. Post coatings preferably comprising one or more metal oxide layers of the elements Al, Si, Zr, Ce or mixtures or mixed phases thereof.. Furthermore, organic or combined organic/inorganic post-coatings are possible. Silanes and/or organofunctional silanes may also be used, alone or in combination with metal oxides. Suitable post-coating or post-treatment methods are, for example, the methods described in DE 22 15 191, DE-A 31 51 354, DE-A 32 35 017 or DE-A 33 34 598, EP 0090259, EP 0 634 459, WO 99/57204, WO 96/32446, WO 99/57204, U.S. 5,759,255, U.S. 5,571,851, WO 01/92425, WO 2011/095326 or other methods known to the person skilled in the art man.

Effect pigments which can be used for the invention are, for example, the commercially available interference pigments or pearlescent pigments offered under the trade names Iriodin®, Pyrisma®, Xirallic®, Miraval®, Colorstream®, RonaStar®, Biflair®, and Lumina Royal®. Other commercially available effect pigments may also be used. Especially, Colorstream®, Xirallic®, Miraval®, and Ronastar® pigments may be used.

For application in a solar cell, the effect pigments are incorporated into an application medium, preferably a transparent coating formulation and subsequently applied to the solar cell.

The application medium may be selected from for example water-based varnishes, solvent-based varnishes, UV curable varnishes, and E-beam curable varnishes, ceramic glazes, sol-gel based component.

The effect pigment may be comprised in a layer on the exterior of the solar cell, on or in any lamination material like EVA (ethyl vinyl acetate film), TPU (thermoplastic polyurethane) or silicone, directly on the photoactive material of the solar cell or on the protective substrate covering a solar cell module. The effect pigment can also be comprised in a sol-gel based, polymer based layer or a layer based on glass frits on the interior or exterior facing glass layer.

Sol-Gel based or polymer based anti-reflection layers on the interior or exterior facing glass layer can also be used according to the invention to implement the effect pigments on any solar cell or solar cell module. One exemplary way is to incorporate the effect pigments in a silica based sol-gel solution made by the hydrolysis of e.g. tetraethyl orthosilicate and the subsequent polycondensation of the solution on the substrate. Another exemplary way is the formation of a glass like layer on the front glass by mixing glass frits commonly used in the printing industry with effect pigments and the subsequent melting of the resulting glass particle mixture. The anti-reflection layers can also be mixed with polymers to create cavities improving the anti-reflective properties during the high temperature step or can be micro structured. Similar ways of creating anti reflective layers known in the industry can also be used to incorporate the effect pigments according to the invention.

The application medium of the invention may also comprise a mixture of different effect pigments, since in many cases the use of at least two different effect pigments makes it possible to obtain special effects. In that case the effect pigments can be mixed in any proportion, although the overall content of all effect pigments in the application medium should not exceed 60% by weight.

The concentration of the effect pigment or mixture of effect pigments is preferably in the range of 1-40%, preferably 1-25 % by weight based on the total weight of solid part of the application medium. Preferably, the amount of effect pigment is in the range of 1 - 15 % by weight, particularly in the range of 2 - 12, especially 3 - 8 % by weight.

The amount of effect pigment in the film in grams per $m^2$ is defined by the film thickness. For example a 20 $\mu$m thick film with 1% effect pigments in the formulation based on the binder medium would translate into ~0,4 g effect pigment per $m^2$ while a 100 $\mu$m thick film with 12% effect pigment would translate into -18 g effect pigment per $m^2$. The general range of effect pigment per $m^2$ of the treated solar surface thus is in the range of 0,1 g per $m^2$ for thin films (1 $\mu$m) and low concentrations up to 75 g per $m^2$ for high concentrations in thick films (200 $\mu$m). The practical range of the invention is in the area of 1-25 g effect pigment per $m^2$, preferably 1-16 g/ $m^2$.

A typical medium is generally prepared by mixing one or more effect pigments with a selected commercially available ready-to-use varnish. A specific varnish can also be made to meet any strict demands.

A typical varnish contains at least: one or more binders and a solvent or a mixture of solvents. In addition the varnish can also contain other additives: anti-foaming agents, anti-sagging agents, dispersing agents, leveling agents, scratch resistance additives, substrate wetting agents, coupling agents, corrosion inhibitors, rheology modifiers, fire redundant, stabilizers, catalysts, odor masking agents, colorants, etc.

A typical application medium of the invention contains effect pigment as described, binder, and solvent, and also can contain other additives: anti-foaming agent anti-sagging agents, dispersing agents, leveling agents, scratch resistance, substrate wetting agents, coupling agents, corrosion inhibitors, rheology modifiers, fire redundant, stabilizers, catalysts, odor masking agents, etc. The application medium may also comprise further colorants.

The application medium is generally prepared by initially introducing one or more effect pigments and mixing them homogeneously with binder, solvent, and any additives.

Binders which can be used are the binders or binder systems usually employed for printing processes, for example aqueous or solvent-containing binders based on nitrocellulose, based on polyamide, based on acrylate, based on polyvinylbutyral, based on PVC, based on PUR or suitable mixtures thereof. Two component systems can be used.

Another option are Ceramic glazes (frits / frit mixtures) which are mixed with the effect pigments of the invention. Ceramic frits and fluxes can be cured in a transparent and colorless manner in order not to hinder the efficiency of the invention.

Preferably, the binders are transparent for visible light, provide good adhesion to solar cell or the lamination or the scratch resistant / protection layer (depend when applied), good stability to the environment, and if used not as the final layer provide good wettability and adhesion to the subsequent layer.

Besides water, it is also possible to employ organic solvents, for example branched or unbranched alcohols, aromatic compounds or alkyl esters, such as ethanol, 1-methoxypropanol, 1-ethoxy-2-propanol, ethyl acetate, butyl acetate, toluene or mixtures comprising these. The respective colored coating formulation may, however, also have a low solvent content or be entirely free from solvents if radiation-curing binder systems, such as, for example, UV-curing binder systems, are used.

Besides the binder or binder system and where appropriate the solvent or solvents, the coating vehicle may, in addition to the respective effect pigments, also comprise various assistants, colorants and/or additives.

Suitable additives are UV stabilizers, inhibitors, flameproofing agents, lubricants, dispersants, re-dispersants, antifoams, flow-control agents, film formers, adhesion promoters, drying accelerators, drying retardants, photoinitiators, etc. The respective coating vehicle preferably comprises all necessary assistants in liquid form in order that the effects of the invention are not weakened or otherwise impaired by additional solids. For this reason, it is especially preferred that neither (soluble) dyes nor other coloring pigments or solid fillers apart from the effect pigments necessary in accordance with the invention are present in the finished colored coating inks.

The pigmented coating formulation can subsequently be applied by various methods, for example, spraying, coating or printing, for example by screen printing, flexo printing, gravure printing, offset printing, inkjet printing, other digital printing methods, slot die coating, spray coating, dip coating, doctor blade / knife coating, curtain coating, film transfer coating, aerosol jetting. Preference is given to screen printing for an optimal trade-off between appearance and the lowest performance loss and spray coating for an optimal appearance at slightly higher power loss.

Dry layer thickness is in the range of 0.1 $\mu$m - 1 mm, preferably 0.5$\mu$m - 200$\mu$m, preferably 1$\mu$m - 50$\mu$m, especially 1$\mu$m - 10$\mu$m.

The concentration of effect pigments in a dry film is about 1 - 20%, preferably 2 - 10%, especially 2 - 6% based on the total weight of the film. The amount of the pigment can even be higher for automotive application

The coating medium comprising effect pigments according to the invention can be applied to any desired solar cell like amorphous, mono- and multi-crystalline silicon solar cells, CIGS, CdTe, III/V solar cells, II/VI solar cells, Perovskite solar cells, organic solar cells and dye sensitized solar cells as well as solar cell modules made out of single cells. Crystalline solar cells include cell structures like Al-BSF, PERC, PERL, PERT, HIT, IBC, bifacial or any other cell type based on crystalline silicon substrates.

The effect pigments can be applied on the exterior of a finished solar cell or solar cell module, on the protective substrate covering the module (glass or plastic), on or in any lamination material like EVA, TPU or silicone or directly on the photoactive material/solar cells. Preference is given to application printing on EVA or printing on finished solar cells or solar cell modules.

A further possibility of application to solar cells or solar cell modular units is the use of a (self-bonding) foil comprising the effect pigments, which may be affixed on glass and other surfaces. This can also be applied to any existing installations of solar cell modules or solar cell mini modules or even single cells in hand-hold devices, transportation vehicles, buildings or similar.

It is particularly advantageous of the invention that it is now possible to seamlessly integrate solar cells into buildings (façade and roof), portable and installed devices, automotive vehicles (cars, motorcycles, scooters, trucks and similar) or other kinds of solar installations where the typical technical look of solar cells would make a change to the typical appearance people are used to. Advantageously, for use in automotive vehicles the effect pigments can be applied within the automotive clear coat. Additionally, this improvement is achieved without significant loss in efficiency.

In order to achieve a fully homogeneous appearance of commonly used silicon solar cells or solar cell modules the metal based conducting parts of the solar cells as well as the solar cell modules (H-grid consisting of main vertical connectors - so called busbars; as well as the horizontal current gathering parts - so called fingers; Connectors and solder between the cells) should be dark colored prior to the application of the effect pigments. Possible ways of "darkening" the else white appearing metal parts of the silicon solar cells or modules with a H-grid front pattern are covering the metal stripes with a black polymer foil or brushing the metal parts with a black paint. In the case of a printed silver H-grid the silver can directly blackened by formation of a thin layer of silver-sulphide (for example by treatment with $H_2S$) or by plating and oxidation of copper. In the case of a plated metal grid the top layer of the metal stack can directly be plated with a strongly absorbing metal oxide or sulphide like CuO or $Ag_2S$ or similar dark colored metal oxides or others. In the case of the usage of novel metallization schemes (like the smart wire technology) blackened wires or wires with a microstructure reducing the reflectance and thus making a dark appearance of the metal grid can also be used according to the invention. If a black or dark solar blue backsheet is used as the module background a very homogeneous appearance of the whole module even from a close distance can be achieved.

The present invention could also lead to improved long-term stability of solar cells and solar cell modules as the effect pigments can partly block or at least prevent water vapor from passing through flexible plastic foils thus acting as an oxygen and water vapor barrier. Many solar cells made out of II/VI or III/V materials as well as organic ones highly suffer from moisture reaching the surface of the solar cell and causing photooxidation of the active materials.

Additionally, the effect pigments can help improving the lifetime of a solar cell or solar cell module due to the absorption of UV light. The absorption in the effect pigment layer leads to less damage in the organic encapsulation and thus less UV absorbers have to be used in these encapsulants and the yellowing due to photooxidation of the polymer is decreased. For this the use of stabilized pigments like described before are essential.

## EXAMPLES

## EXAMPLE 1:

c-Si solar cells (CZ) are coated with different layers comprising different effect pigments, different effect pigment concentrations and/or effect pigment mixtures. The layers comprising effect pigments render the surface appearance of sheets of encapsulated materials to different colors, as e. g. green or violet.

For example, an ink containing Pyrisma® Green (3%) in Proell Aqua Jet FGL M 093 varnish (95,5%) and Proell Defoamer L36459 (1,5%) is printed on a standard c-Si panels using manual flat-bed screen printer. Mesh PET1500 54/137-64W from Sefar is used (parameters of the mesh: 137 l/inch, 115$\mu$m mesh opening and 64$\mu$m thread diameter). Squeegee used for printing is a manual squeegee with hardness of 75° shore. The layer is dried at room temperature in ambient conditions.

Further effect pigments and effect pigment concentrations are listed in Table 1.

**Table 1**

| Example (Cell) | Pigment | Pigment Concentration | Pigment g/m² |
|---|---|---|---|
| | | | |
| 1 | Colorstream® Viola Fantasy | 12% | 3,1 |
| 2 | Pyrisma® Green | 12% | 3,1 |
| 3 | Colorstream® Tropic Sunrise | 12% | 3,1 |
| 4 | Miraval® (formerly Colorstream®) Pacific Twinkle | 3% | 2,3 |
| 5 | Pyrisma® Green | 6% | 3,1 |
| 6 | Miraval® 5402 Pacific Twinkle | 6% | 3,1 |
| 7 | Miraval® 5426 Magic Green | 3% | 3,1 |
| 8 | Miraval® 5426 Magic Green | 6% | 0,8 |
| 9 | Iriodin® 231 Rutile Fine Green | 3% | 1,6 |
| 10 | Iriodin® 231 Rutile Fine Green | 6% | 1,6 |
| 11 | Iriodin® 231 Rutile Fine Green | 9% | 0,8 |
| 12 | Iriodin® 299 Flash Green | 3% | 1,6 |
| 13 | Iriodin® 299 Flash Green | 6% | 0,8 |
| 14 | Iriodin® 299 Flash Green | 9% | 1,6 |
| 15 | Xirallic® T60-24 Stellar Green | 6% | 2,3 |
| 16 | Xirallic® T60-24 Stellar Green | 9% | 3,1 |
| 17 | Xirallic® T60-24 Stellar Green | 12% | 0,8 |
| 18 | Pyrisma® T30-24 Green | 3% | 1,6 |
| 19 | Colorstream® T10-01 Viola Fantasy | 3% | 2,3 |
| 20 | Colorstream® T10-01 Viola Fantasy | 6% | 1,6 |

(continued)

| Example (Cell) | Pigment | Pigment Concentration | Pigment g/m$^2$ |
|---|---|---|---|
| 21 | Colorstream® T10-01 Viola Fantasy | 9% | 2,3 |
| 22 | H$_2$O-Lack "Pröll FGL M093" | no pigment | no pigment |
| 23 | UV-Lack "Schmid Rhyner Wessco 34.238.30" | no pigment | no pigment |
| 24 | Pyrisma® Green Mirror (HM 43-16) | 6% | 1,6 |

Impacts of pigment layers onto c-Si solar cells are assessed by reflection measurements.

Reflection data are used to estimate max. power absorption / max. photo current generation of treated cells: Spectral reflectance is recorded in wavelength interval between 280 nm to 1200 nm.

Transmission of cells artificially set to zero (as this is also expected for real-life conditions of Si solar cells comprising an almost completely rear side coverage of sintered and alloyed aluminium paste which conventionally forms the rear side electrode of such devices).

Regularly full absorption of short wavelength light by cell's bulk
Calculation of absorption of light by whole system
Absorption in pigment layers, SiNx and Al neglected (since unknown)

Transposition of power absorption to max. achievable photo current based on AM1.5G spectrum (according to IEC 60904-3 Ed. 2 which is equivalent to ASTM G173-03). For this purpose, afore-mentioned reference spectrum is taken and irradiation intensity is re-calculated by interpolation of spectrum applying single nanometer resolution as stepwidth for the wavelength regime of 280 nm to 1200 nm. Integration of the interpolated spectrum yields a total irradiation intensity of 835.998 W/m$^2$. Latter is very good agreement with integral for the same wavelength range of the original reference spectrum whose irradiation intensity amounts to 836.19 W/m$^2$. The difference between the original spectrum and the interpolated one amounts to 0.2 ‰.

Reflectance standard (PTFE)
Cary 5000 (UV/ViS/NIR); Agilent
All cells (where applicable) are probed 4-time
Cells are subjected to reflectivity measurement
Measurement setup is checked by using 'reference sample'
Light incidence perpendicular to surface of cells
Reflectivity is measured from front side of cells

- Front side: within this context, solar cell's surface covered by SiN$_x$ is per definition considered as the so-called "front side"; colored, opposite to full Al electrode
- Measurements are performed with three repetitions (4 measurements in total)

Irradiated surface is amounted to cover large area fractions up to 1 cm in diameter.

Thus, reflectance data are averaged integrals comprising metallized/non-metallized surface.

Measured data are averaged and averages are used for further considerations:

Averaged mean reflectance of the cell
Estimation of standard deviation & variance
Estimation of T-error range according to probability of 99 % (confidence interval)
carried out using PTFE-standard as reference

Sample beam not covered and sealed by light absorbing lid during measurement in order to not unintentionally damage of destroy fragile silicon solar cells.

Results are summarized in Table 2.

**Table 2**

| | max. Power Absorbed [W/m²] | rel. Power Loss [%] | max. Photo Current Possible [A/m²] | rel. Current Loss [%] |
|---|---|---|---|---|
| AM1.5G | 836.0 | 0.00 | 464.4 | 0.00 |
| Reference | 769.9 | 0.00 | 427.7 | 0.00 |
| Cell 01 (violet) | 650.0 | -15.57 | 370.0 | -13.49 |
| Cell 02 (green) | 656.5 | -14.73 | 364.4 | -14.80 |
| Cell 03 (green) | 524.2 | -31.91 | 285.7 | -33.20 |
| Cell 04 | 739.5 | -3.96 | 408.4 | -4.51 |
| Cell 05 | 698.7 | -9.25 | 387.2 | -9.46 |
| Cell 6 | 702.0 | -8.83 | 387.4 | -9.43 |
| Cell 7 | 752.0 | -2.33 | 416.1 | -2.71 |
| Cell 8 | 738.3 | -4.11 | 408.7 | -4.44 |
| Cell 9 | 724.2 | -5.93 | 401.1 | -6.22 |
| Cell 10 | 684.7 | -11.07 | 379.8 | -11.19 |
| Cell 11 | 651.6 | -15.37 | 361.7 | -15.42 |
| Cell 12 | 743.2 | -3.47 | 411.5 | -3.80 |
| Cell 13 | 715.9 | -7.01 | 397.2 | -7.13 |
| Cell 14 | 693.0 | -9.99 | 384.9 | -10.01 |
| Cell 15 | 706.9 | -8.18 | 392.9 | -8.14 |
| Cell 16 | 681.3 | -11.51 | 379.1 | -11.35 |
| Cell 17 | 654.5 | -15.00 | 364.5 | -14.77 |
| Cell 18 | 733.4 | -4.75 | 406.0 | -5.08 |
| Cell 19 | 727.8 | -5.47 | 407.2 | -4.80 |
| Cell 20 | 691.3 | -10.21 | 390.0 | -8.82 |
| Cell 21 | 661.2 | -14.12 | 375.6 | -12.18 |
| Cell 22 | 774.4 | 0.59 | 428.2 | 0.11 |
| Cell 23 | 777.7 | 1.02 | 429.8 | 0.49 |
| Cell 24 | 702.5 | -8.76 | 389.6 | -8.91 |

## Example 2:

Solar mini modules are prepared in a way that layers containing effect pigments according to the invention in a water based resin are directly printed on commercially available Al-BSF solar cells. The modules are afterwards contacted by manual soldering and encapsulated between a glass plate and a tedlar backsheet using either thermoplastic polyurethane (TPU) or ethyl-vinyl acetate (EVA). The efficiency is measured in standardized setup under AM1.5.

While the uncoated reference module shows an efficiency of up to 17.6% none of the tested solar mini modules shows a drop in efficiency exceeding 10% (rel.). Even a white appearing module shows an effective efficiency of 16% due to the selective reflection of light caused by effect pigments.

## Example 3:

Solar mini modules are prepared in a way that layers containing effect pigments according to the invention in a water based glass / frits mixtures are directly printed on commercially available low iron glass used for solar modules by screen printing and afterwards tempered at 600°C-680°C in an oven. In a second step a grid with colored ceramic color is printed on top of the layer in a design to be able to cover the bright areas like the space between single cells and the bus bars, conducting path and soldering points.

Modules are prepared with the following steps before it is fused.

- Glass plate covered with dark blue colored backsheet out of thermoplastic polyurethane (TPU) or ethyl-vinyl acetate (EVA). In this case a black multilayer backsheet from Dymat (Bk PYE SPV-L).
- Cells are placed and contacted by manual melding
- Second sheet out of thermoplastic polyurethane (TPU) or ethyl-vinyl acetate (EVA) is placed on top of the cells.
- On top the colored glass plate is placed in a manner that all remaining bright areas are covered by the dark grid.
- Module is heated at 100°C in an vacuum oven to seal the module.

The efficiency is measured in standardized setup under AM1.5 conditions.

While the uncoated reference module shows an efficiency of up to 17.6% none of the tested solar mini modules shows a drop in efficiency exceeding 20% (rel.). Even a white appearing module shows an effective efficiency of 15.1% due to the selective reflection of light caused by effect pigments.

## Example 4:

A semi-transparent organic solar cell with an integrated blue LED (powered by the organic solar cell) is printed with an ink containing Pyrisma® Green (3%) in Proell Aqua Jet FGL M 093 varnish (95,5%) and Proell Defoamer L36459 (1,5%) is printed using manual flat-bed screen printer. Mesh PET1500 54/137-64W from Sefar is used (parameters of the mesh: 137 l/inch, 115 μm mesh opening and 64μm thread diameter). Squeegee used for printing is a manual squeegee with hardness of 75° shore. The layer is dried at room temperature in ambient conditions. The brightness of the LED integrated in the organic solar is based on its generated current and can thus be used to measure the efficiency. The LED shows the same brightness under illumination from the printed or non-printed side thus the effect pigment coating has a negligible impact on the current and efficiency of the organic solar cell.

## Example 5:

Spray coating of solar cells with effect pigment containing lacquer

Standard solar cells are by spray application with the regularly used devices.

The used pearlescent pigment, in this case green interference pigments, are stirred in a commercially available 2K refinish clearcoat from MIPA (MIPA CC4 2K Klarlack), the used concentration here is 1,13% on formulation. The coating is prepared as recommended by the supplier and adjusted to an application viscosity of 70 -75 mPas at1000 1/s.

Following effect pigments were used:

Iriodin® 9231 SW
Iriodin® 9235 SW
Iriodin® 97235 SW
Miraval® Green
Xirallic® Stellar Green SW

For the application of the so prepared coating on the solar cells an automated spraying device Oerter APL4.6 is used. In this case the coating is applied with a 1,4mm nozzle in two cycles following each other immediately. Before stoving at 70° C for 60 min the coating is allowed to dry at room temperature for 10 min. In the end a dry film thickness of about 40μm is achieved.

The characteristic of green interference pigments is visible clearly on the solar cell panels, in certain angles the green color is visible, in others not. To characterize the panels and the effect of the used effect pigments on the efficiency of the panels further, measurement of reflectivity is done on the coated front side of the cells. Therefore, a Cary 5000 (UV/VIS/NIR) Agilent is used. As reference a not coated standard solar cell is used. With this setup it is determined that the rel. loss of achievable current is only between 4,5% (Xirallic® Stellar Green SW) and 6,7% (Iriodin® 9235 SW) depending on the used green interference pigment compared to a not coated solar cell.

## Claims

**1.** Solar cell or solar cell module comprising at least one layer on or in the front radiation-receiving side of the solar cell or solar cell module comprising at least one effect pigment consisting of a transparent or semi-transparent flake-form substrate coated with one or more layers of transparent or semi-transparent materials and optionally with a post coating, **characterized in that** the effect pigment has a reflection level of 1 to 40% for radiation in the range of 260 to 1200 nm, and the amount of the effect pigment is in the range of 1 - 25 g/m$^2$.

2. Solar cell or solar cell module according to claim 1, where the effect pigment and/or the effect pigment layer selectively reflects 5-40% of the visible light of the solar spectrum.

3. Solar cell or solar cell module according to one or more of claims 1 to 2, where the effect pigment and/or the effect pigment layer has a transparency for radiation relevant for the specific solar cell or solar cell module, preferably for radiation in the range of 260 to 1200 nm, of > 80%.

4. Solar cell or solar cell module according to one or more of claims 1 to 3, where the effect pigment and/or the effect pigment layer has a reflection level of < 30% for radiation in the range of 260 to 1200 nm.

5. Solar cell or solar cell module according to one or more of claims 1 to 4, where the effect pigment and/or the effect pigment layer has a reflection level of < 20% for radiation in the range of 260 to 1200 nm.

6. Solar cell or solar cell module according to one or more of claims 1 to 5, where the effect pigment is selected from pearlescent pigments, interference pigments and multi-layer pigments.

7. Solar cell or solar cell module according to one or more of claims 1 to 6, where the amount of effect pigment in the application medium is in the range of 1-15 % by weight based on the solid parts of the application medium.

8. Solar cell or solar cell module according to one or more of claims 1 to 7, where the amount of effect pigment is in the range of 1 - 16 g per m2.

9. Solar cell or solar cell module according to one or more of claims 1 to 8, where the thickness of the effect pigment comprising layer is in the range of 1 to 200 $\mu$m.

10. Solar cell or solar cell module according to one or more claims 1 to 9, where the internal quantum efficiency is of $\geq$ 0,7 preferable $\geq$ 0,8 in the area of 260 to 1200 nm wavelength.

11. Solar cell or solar cell module according to one or more claims 1 to 10, where the effect pigment and/or the effect pigment layer creates a relative current loss [A/m$^2$] of less than 40 %, preferably less than 30%, most preferably less than 20%.

12. Solar cell or solar cell module according to one or more claims 1 to 11, where the effect pigment and/or the effect pigment layer creates an efficiency reduction [W/m$^2$] of less than 40 %, preferable less than 30%, most preferably less than 20%.

13. Solar cell or solar cell module according to one or more claims 1 to 12, where the external quantum efficiency is of $\geq$ 0,6 preferably of $\geq$ 0,8 in the area of 260 to 1200 nm wavelength.

14. Solar cell or solar cell module according to one or more of claims 1 to 13, where the effect pigment is based on a flake-form glass substrate or a flake-form $SiO_2$ substrate or a flake-form $Al_2O_3$ substrate.

15. Solar cell or solar cell module according to one or more of claims 1 to 14, where the flake-form substrate is coated with one or more layers of metal oxides and/or metal oxide hydrates of Ti, Sn, Si, Al, Zr and Zn.

16. Solar cell or solar cell module according to one or more of claims 1 to 15, where the effect pigment is comprised in a layer on the exterior of the solar cell, on or in any lamination material like EVA (ethyl vinyl acetate film), TPU (thermoplastic polyurethane) or silicone, directly on the photoactive material of the solar cell or on the protective substrate covering a solar cell module.

17. Solar cell or solar cell module according to one or more of claims 1 to 16, where the effect pigment is comprised in a sol-gel based, polymer based layer or a layer based on glass frits on the interior or exterior facing glass layer.

18. Solar cell or solar cell module according to one or more of claims 1 to 17, where the metal based conducting parts of the solar cells as well as of the solar cell modules are dark colored prior to the assembly of the solar cell module and a black or dark blue back sheet is used.

19. Solar cell or solar cell module according to one or more of claims 1 to 18, where on top of the effect pigment layer a dark colored pattern is placed covering bright areas like the space between single cells and the bus bars, conducting path and soldering points or where metal based conducting parts of the solar cells or solar cell modules are dark colored or where a black or dark blue back sheet is located on the rear side of the solar cells or solar cell modules.

20. Process for the preparation of solar cells or solar cell modules according to claims 1 to 19 where a coating composition comprising an effect pigment comprising a transparent or semi-transparent flake-form substrate coated with one or more layers of transparent or semi-transparent materials and optionally a post coating, one or multiple binders like organic or inorganic binders, and optionally additives is applied to the solar cells or solar cell modules.

21. Process according to claim 20, where the coating composition is applied by screen printing, flexo printing, gravure printing, offset printing, inkjet printing, other digital printing methods, slot die coating, spray coating, dip coating, doctor blade / knife coating, curtain coating, film transfer coating or aerosol jetting.

22. Process according to claims 20 to 21 where on top of the coating composition comprising effect pigments a dark colored pattern is placed covering bright areas like the space between single cells and the bus bars, conducting path and soldering points.

23. Process according to claims 20 to 22 where metal based conducting parts of the solar cells are dark colored.

24. Process according to claims 20 to 23 where a black or dark blue back sheet is applied on the rear side of the solar cells or solar cell modules.

**Patentansprüche**

1. Solarzelle oder Solarzellenmodul enthaltend mindestens eine Schicht auf oder in der vorderen strahlenempfangenden Seite der Solarzelle oder des Solarzellenmoduls, enthaltend mindestens ein Effektpigment, das aus einem transparenten oder semitransparenten plättchenförmigen Substrat besteht, das mit einer oder mehreren Schichten aus transparenten oder semitransparenten Materialien und gegebenenfalls mit einer Nachbeschichtung beschichtet ist, **dadurch gekennzeichnet, dass** das Effektpigment ein Reflexionsniveau von 1 bis 40% für Strahlung im Bereich von 260 bis 1200 nm aufweist und die Menge des Effektpigments im Bereich von 1 - 25 g/m$^2$ liegt.

2. Solarzelle oder Solarzellenmodul nach Anspruch 1, wobei das Effektpigment und/oder die Effektpigmentschicht selektiv 5-40% des sichtbaren Lichts des Sonnenspektrums reflektiert.

3. Solarzelle oder Solarzellenmodul nach einem oder mehreren der Ansprüche 1 bis 2, wobei das Effektpigment und/oder die Effektpigmentschicht eine Durchlässigkeit für Strahlung, die für die spezifische Solarzelle oder das spezifische Solarzellenmodul relevant ist, vorzugsweise für Strahlung im Bereich von 260 bis 1200 nm, von > 80% aufweist.

4. Solarzelle oder Solarzellenmodul nach einem oder mehreren der Ansprüche 1 bis 3, wobei das Effektpigment und/oder die Effektpigmentschicht ein Reflexionsniveau von < 30% für Strahlung im Bereich von 260 bis 1200 nm aufweist.

5. Solarzelle oder Solarzellenmodul nach einem oder mehreren der Ansprüche 1 bis 4, wobei das Effektpigment und/oder die Effektpigmentschicht ein Reflexionsniveau von < 20% für Strahlung im Bereich von 260 bis 1200 nm aufweist.

6. Solarzelle oder Solarzellenmodul nach einem oder mehreren der Ansprüche 1 bis 5, wobei das Effektpigment aus Perlglanzpigmenten, Interferenzpigmenten und Mehrschichtpigmenten ausgewählt ist.

7. Solarzelle oder Solarzellenmodul nach einem oder mehreren der Ansprüche 1 bis 6, wobei die Menge an Effektpigment im Anwendungsmedium im Bereich von 1-15 Gew.-% liegt, bezogen auf den Festkörperanteil des Anwendungsmediums.

8. Solarzelle oder Solarzellenmodul nach einem oder mehreren der Ansprüche 1 bis 7, wobei die Menge an Effektpigment im Bereich von 1 - 16 g pro m² liegt.

9. Solarzelle oder Solarzellenmodul nach einem oder mehreren der Ansprüche 1 bis 8, wobei die Dicke der effektpigmenthaltigen Schicht im Bereich von 1 bis 200 µm liegt.

10. Solarzelle oder Solarzellenmodul nach einem oder mehreren der Ansprüche 1 bis 9, wobei die interne Quanteneffizienz $\geq 0{,}7$, vorzugsweise $\geq 0{,}8$ im Gebiet von 260 bis 1200 nm Wellenlänge ist.

11. Solarzelle oder Solarzellenmodul nach einem oder mehreren der Ansprüche 1 bis 10, wobei das Effektpigment und/oder die Effektpigmentschicht einen relativen Stromverlust [A/m²] von weniger als 40%, vorzugsweise weniger als 30%, am stärksten bevorzugt weniger als 20% verursacht.

12. Solarzelle oder Solarzellenmodul nach einem oder mehreren der Ansprüche 1 bis 11, wobei das Effektpigment und/oder die Effektpigmentschicht eine Effizienzverminderung [W/m²] von weniger als 40%, vorzugsweise weniger als 30%, am stärksten bevorzugt weniger als 20% verursacht.

13. Solarzelle oder Solarzellenmodul nach einem oder mehreren der Ansprüche 1 bis 12, wobei die externe Quanteneffizienz $\geq 0{,}6$, vorzugsweise $\geq 0{,}8$ im Gebiet von 260 bis 1200 nm Wellenlänge ist.

14. Solarzelle oder Solarzellenmodul nach einem oder mehreren der Ansprüche 1 bis 13, wobei das Effektpigment auf einem plättchenförmigen Glassubstrat oder einem plättchenfömigen $SiO_2$-Substrat oder einem plättchenfömigen $Al_2O_3$-Substrat basiert.

15. Solarzelle oder Solarzellenmodul nach einem oder mehreren der Ansprüche 1 bis 14, wobei das plättchenförmige Substrat mit einer oder mehreren Schichten von Metalloxiden und/oder Metalloxidhydraten von Ti, Sn, Si, Al, Zr und Zn beschichtet ist.

16. Solarzelle oder Solarzellenmodul nach einem oder mehreren der Ansprüche 1 bis 15, wobei das Effektpigment in einer Schicht auf dem Äußeren der Solarzelle, auf oder in einem beliebigen Laminierungsmaterial wie EVA (Ethylvinylacetat-Folie), TPU (thermoplastisches Polyurethan) oder Silikon, direkt auf dem photoaktiven Material der Solarzelle oder auf dem ein Solarzellenmodul bedeckenden Schutzsubstrat enthalten ist.

17. Solarzelle oder Solarzellenmodul nach einem oder mehreren der Ansprüche 1 bis 16, wobei das Effektpigment in einer Sol-Gel-basierten, polymerbasierten Schicht oder einer Schicht auf der Basis von Glasfritten auf der nach innen oder nach außen gerichteten Glasschicht enthalten ist.

18. Solarzelle oder Solarzellenmodul nach einem oder mehreren der Ansprüche 1 bis 17, wobei die metallbasierten leitenden Teile der Solarzellen und der Solarzellenmodule vor der Montage des Solarzellenmoduls dunkelfarbig sind und eine schwarze oder dunkelblaue Rückplatte verwendet wird.

19. Solarzelle oder Solarzellenmodul nach einem oder mehreren der Ansprüche 1 bis 18, wobei auf der Effektpigmentschicht ein dunkelfarbiges Muster platziert wird, das helle Gebiete wie den Raum zwischen einzelnen Zellen und den Sammelschienen, Leiterbahn und Lötstellen abdeckt, oder wobei metallbasierte Leiterbahnen der Solarzellen oder Solarzellenmodule dunkelfarbig sind oder wobei eine schwarze oder dunkelblaue Rückplatte auf der Rückseite der Solarzellen oder Solarzellenmodule angeordnet ist.

20. Verfahren zur Herstellung von Solarzellen oder Solarzellenmodulen nach den Ansprüchen 1 bis 19, wobei eine Beschichtungszusammensetzung, die ein Effektpigment, das ein transparentes oder semitransparentes plättchenförmiges Substrat enthält, das mit einer oder mehreren Schichten aus transparenten oder semitransparenten Materialien und gegebenenfalls einer Nachbeschichtung beschichtet ist, einen oder eine Vielzahl von Bindemitteln wie organische oder anorganische Bindemittel und gegebenenfalls Zusatzstoffe enthält, auf die Solarzellen oder Solarzellenmodule aufgebracht wird.

21. Verfahren nach Anspruch 20, wobei die Beschichtungszusammensetzung durch Siebdruck, Flexodruck, Tiefdruck, Offsetdruck, Tintenstrahldruck, andere digitale Druckverfahren, Schlitzdüsenbeschichtung, Sprühbeschichtung, Tauchbeschichtung, Rakel-/Streichbeschichtung, Vorhangbeschichtung, Folientransferbeschichtung oder Versprühen von Aerosolen aufgebracht wird.

22. Verfahren nach den Ansprüchen 20 bis 21, wobei auf der Effektpigmente enthaltenden Beschichtungszusammensetzung ein dunkelfarbiges Muster platziert wird, das helle Gebiete wie den Raum zwischen einzelnen Zellen und den Sammelschienen, Leiterbahn und Lötstellen abdeckt.

23. Verfahren nach den Ansprüchen 20 bis 22, wobei metallbasierte Leiterbahnen der Solarzellen dunkelfarbig sind.

24. Verfahren nach den Ansprüchen 20 bis 23, wobei eine schwarze oder dunkelblaue Rückplatte auf der Rückseite der Solarzellen oder Solarzellenmodule angebracht wird.

**Revendications**

1. Cellule solaire ou module de cellules solaires comprenant au moins une couche sur ou dans la face avant de réception du rayonnement de la cellule solaire ou du module de cellules solaires comprenant au moins un pigment à effet constitué d'un substrat transparent ou semi-transparent, sous forme de paillettes, revêtu d'une ou plusieurs couches de matériaux transparents ou semi-transparents et éventuellement d'un post-revêtement, caractérisé(e) en que le pigment à effet présente un taux de réflexion allant de 1 à 40% pour un rayonnement dans la plage allant de 260 à 1200 nm, et que la quantité de pigment à effet se trouve dans la plage de 1 - 25 g/m$^2$.

2. Cellule solaire ou module de cellules solaires selon la revendication 1, dans laquelle/lequel le pigment à effet et/ou la couche de pigments à effet réfléchit de manière sélective 5-40% de la lumière visible du spectre solaire.

3. Cellule solaire ou module de cellules solaires selon l'une ou plusieurs parmi les revendications 1 à 2, dans laquelle/lequel le pigment à effet et/ou la couche de pigments à effet présente une transparence pour le rayonnement pertinent pour la cellule solaire ou le module de cellules solaires spécifique, préférablement pour un rayonnement dans la plage allant de 260 à 1200 nm, de > 80%.

4. Cellule solaire ou module de cellules solaires selon l'une ou plusieurs parmi les revendications 1 à 3, dans laquelle/lequel le pigment à effet et/ou la couche de pigments à effet présente un taux de réflexion < 30% pour un rayonnement dans la plage allant de 260 à 1200 nm.

5. Cellule solaire ou module de cellules solaires selon l'une ou plusieurs parmi les revendications 1 à 4, dans laquelle/lequel le pigment à effet et/ou la couche de pigments à effet présente un taux de réflexion < 20% pour un rayonnement dans la plage allant de 260 à 1200 nm.

6. Cellule solaire ou module de cellules solaires selon l'une ou plusieurs parmi les revendications 1 à 5, dans laquelle/lequel le pigment à effet est choisi parmi les pigments nacrés, les pigments interférentiels et les pigments multicouches.

7. Cellule solaire ou module de cellules solaires selon l'une ou plusieurs parmi les revendications 1 à 6, dans laquelle/lequel la quantité de pigment à effet dans le milieu d'application se trouve dans la plage de 1-15% en poids sur la base des parties solides du milieu d'application.

8. Cellule solaire ou module de cellules solaires selon l'une ou plusieurs parmi les revendications 1 à 7, dans laquelle/lequel la quantité de pigment à effet se trouve dans la plage de 1 - 16 g par m$^2$.

9. Cellule solaire ou module de cellules solaires selon l'une ou plusieurs parmi les revendications 1 à 8, dans laquelle/lequel l'épaisseur de la couche comprenant le pigment à effet se trouve dans la plage allant de 1 à 200 $\mu$m.

10. Cellule solaire ou module de cellules solaires selon l'une ou plusieurs parmi les revendications 1 à 9, dans laquelle/lequel le rendement quantique interne est $\geq$ 0,7 préférablement $\geq$ 0,8 dans la région de longueur d'onde allant de 260 à 1200 nm.

11. Cellule solaire ou module de cellules solaires selon l'une ou plusieurs parmi les revendications 1 à 10, dans laquelle/lequel le pigment à effet et/ou la couche de pigments à effet entraîne une perte de courant relative [A/m$^2$] inférieure

à 40%, préférablement inférieure à 30%, tout préférablement inférieure à 20%.

12. Cellule solaire ou module de cellules solaires selon l'une ou plusieurs parmi les revendications 1 à 11, dans laquelle/lequel le pigment à effet et/ou la couche de pigments à effet entraîne une réduction de rendement [W/m$^2$] inférieure à 40%, préférablement inférieure à 30%, tout préférablement inférieure à 20%.

13. Cellule solaire ou module de cellules solaires selon l'une ou plusieurs parmi les revendications 1 à 12, dans laquelle/lequel le rendement quantique externe est $\geq 0,6$ préférablement $\geq 0,8$ dans la région de longueur d'onde allant de 260 à 1200 nm.

14. Cellule solaire ou module de cellules solaires selon l'une ou plusieurs parmi les revendications 1 à 13, dans laquelle/lequel le pigment à effet est basé sur un substrat de verre en forme de paillettes ou un substrat de SiO$_2$ en forme de paillettes ou un substrat de Al$_2$O$_3$ en forme de paillettes.

15. Cellule solaire ou module de cellules solaires selon l'une ou plusieurs parmi les revendications 1 à 14, dans laquelle/lequel le substrat en forme de paillettes est revêtu par une ou plusieurs couches d'oxydes métalliques et/ou d'hydrates d'oxydes métalliques de Ti, Sn, Si, Al, Zr et Zn.

16. Cellule solaire ou module de cellules solaires selon l'une ou plusieurs parmi les revendications 1 à 15, dans laquelle/lequel le pigment à effet est compris dans une couche à l'extérieur de la cellule solaire, sur ou dans un matériau de lamination quelconque tel que l'EVA (film d'éthylène-acétate de vinyle), le TPU (polyuréthane thermoplastique) ou la silicone, directement sur le matériau photo-actif de la cellule solaire ou sur le substrat protecteur recouvrant un module de cellules solaires.

17. Cellule solaire ou module de cellules solaires selon l'une ou plusieurs parmi les revendications 1 à 16, dans laquelle/lequel le pigment à effet est compris dans une couche à base de polymère, à base d'un sol-gel, ou une couche à base de frittes de verre sur la couche de verre faisant face à l'intérieur ou l'extérieur.

18. Cellule solaire ou module de cellules solaires selon l'une ou plusieurs parmi les revendications 1 à 17, dans laquelle/lequel les parties conductrices à base de métal des cellules solaires ainsi que des modules de cellules solaires sont de couleur foncée avant l'assemblage du module de cellules solaires et on utilise une feuille arrière noire ou bleu foncé.

19. Cellule solaire ou module de cellules solaires selon l'une ou plusieurs parmi les revendications 1 à 18, dans laquelle/lequel, sur la couche de pigments à effet, un motif de couleur foncée est placé pour couvrir les zones claires telles que l'espace entre les cellules individuelles et les barres omnibus, le chemin conducteur et les points de soudure ou où les parties conductrices à base de métal des cellules solaires ou des modules de cellules solaires sont de couleur foncée ou où une feuille arrière noire ou bleu foncé est située sur la face arrière des cellules solaires ou des modules de cellules solaires.

20. Procédé de préparation de cellules solaires ou de modules de cellules solaires selon les revendications 1 à 19, dans lequel une composition de revêtement comprenant un pigment à effet comprenant un substrat transparent ou semi-transparent, sous forme de paillettes, revêtu d'une ou plusieurs couches de matériaux transparents ou semi-transparents et éventuellement d'un post-revêtement, un ou plusieurs liants tels que des liants organiques ou inorganiques, et éventuellement des additifs, est appliquée aux cellules solaires ou aux modules de cellules solaires.

21. Procédé selon la revendication 20, dans lequel la composition de revêtement est appliquée par sérigraphie, flexographie, héliogravure, impression offset, impression à jet d'encre, d'autres méthodes d'impression numérique, revêtement à filière plate, revêtement par pulvérisation, revêtement par immersion, revêtement par racle/couteau, revêtement par rideau, revêtement par transfert de film ou par projection d'aérosol.

22. Procédé selon les revendications 20 à 21, dans lequel, sur la composition de revêtement comprenant des pigments à effet, un motif de couleur foncée est placé pour couvrir les zones claires telles que l'espace entre les cellules individuelles et les barres omnibus, le chemin conducteur et les points de soudure.

23. Procédé selon les revendications 20 à 22, dans lequel les parties conductrices à base de métal des cellules solaires sont de couleur foncée.

24. Procédé selon les revendications 20 à 23, dans lequel une feuille arrière noire ou bleu foncé est appliquée sur la face arrière des cellules solaires ou des modules de cellules solaires.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5648906 B
- WO 07050756 A
- WO 09143407 A
- US 2011023943 A
- WO 2007050756 A2
- WO 2011095326 A1
- DE 2215191
- DE 3151354 A
- DE 3235017 A
- DE 3334598 A
- EP 0090259 A
- EP 0634459 A
- WO 9957204 A
- WO 9632446 A
- US 5759255 A
- US 5571851 A
- WO 0192425 A
- WO 2011095326 A